# EUROPÄISCHE PATENTSCHRIFT

(11) **EP 0 511 211 B1**
(45) Veröffentlichungstag und Bekanntmachung des Hinweises auf die Patenterteilung: **14.09.1994**
(21) Anmeldenummer: 90916249.7
(22) Anmeldetag: 13.11.1990
(51) Int. Cl.: H05K 9/00

(54) **ABSCHIRMBEHÄLTNIS FÜR EINEN BEREICH EINER LEITERPLATTE**
SCREENING CONTAINER FOR A REGION OF A PRINTED CIRCUIT BOARD
ENVELOPPE DE BLINDAGE POUR UNE REGION D'UNE PLAQUETTE A CIRCUITS IMPRIMES

(30) Priorität: 08.01.1990 DE 4000286
(43) Veröffentlichungstag der Anmeldung: 04.11.1992
(73) Patentinhaber: ROBERT BOSCH GMBH, 70442 Stuttgart (DE)
(72) Erfinder: KOPPATZ, Dietmar, D-7257 Ditzingen (DE); SÖHNER, Gerhard, D-7064 Geradstetten (DE); SCHRAY, Hans-Dieter, D-7145 Markgröningen 2 (DE); BENZINGER, Heinz, D-7251 Wimsheim (DE); BANZHAF, Gerald, D-7000 Stuttgart 31 (DE)
(86) Internationale Anmeldenummer: DE9000865
(87) Internationale Veröffentlichungsnummer: WO9111092

(56) Entgegenhaltungen:
- EP-A- 0 262 332
- DE-U- 6 806 496
- FR-A- 2 565 061

## Beschreibung

### Stand der Technik

Die Erfindung betrifft ein Abschirmbehältnis für einen Bereich einer Leiterplatte, mit einer auf der einen Seite der Leiterplatte angeordneten ersten und einer auf der anderen Seite der Leiterplatte angeordneten zweiten Halbschale sowie mit Befestigungsmitteln für die Halbschalen.

Bei elektronischen, auf Leiterplatten angeordneten Schaltungen tritt häufig das Problem auf, eine bestimmte Baugruppe abzuschirmen. Beispielsweise erzeugen digitale Schaltungen zumeist aufgrund steiler Umschaltflanken diskrete Hochfrequenz-Impulse (HF-Impulse) und stören andere Baugruppen oder Geräte (z.B. Geräte der mobilen Kommunikation, wie Radio, Funk, Autotelefon). Gegen Störungen durch derartige elektromagnetische Felder sind wirksame Vorkehrungen zu treffen.

Es ist bekannt, sogenannte Abschirmbehältnisse (Abschirmboxen oder Abschirmdosen) einzusetzen, die aus zwei Halbschalen bestehen. Dabei ist es nicht erforderlich, daß die beiden Halbschalen identisch ausgebildet sind, sondern sie können zum Beispiel eine unterschiedliche Bauhöhe aufweisen. Siehe z.B. FR-A-2 565 061 und DE-U-6 806 496 Die eine Halbschale wird auf der einen Seite der Leiterplatte und die andere Halbschale auf der anderen Seite der Leiterplatte angeordnet, so daß der hierdurch umschlossene Raum elektromagnetisch abgeschirmt wird. Das Zusammenfügen der beiden Halbschalen kann mittels Schrauben erfolgen, was jedoch eine relativ teuere und montageaufwendige Lösung ist. Ferner ist die Befestigung mit Nieten möglich, die jedoch auch teuer ist und zu schwer lösbaren Verbindungen führt. Überdies ist es bekannt, die beiden Halbschalen miteinander zu verlöten, so daß auch hier eine schwer lösbare Verbindung vorliegt. Sofern die Befestigung mit Stecklaschen erfolgt, liegt nur eine mechanisch ungenügende Festigkeit vor, wobei hinzukommt, daß die elektrische Kontaktierung zwischen den beiden Halbschalen im hochfrequenztechnischen Sinne mangelhaft ist.

### Vorteile der Erfindung

Das erfindungsgemäße Abschirmbehältnis mit den im Hauptanspruch genannten Merkmalen hat demgegenüber den Vorteil, daß eine besonders einfache und kostengünstige Lösung vorliegt, die eine leichte Montage und Demontierbarkeit ermöglicht, ein im hochfrequenztechnischen Sinne besonders dichtes Zusammenfügen der beiden Halbschalen ermöglicht und dabei einen HF-technisch einwandfreien Kontakt herstellt. Hierzu sind am Rand der einen Halbschale Laschen ausgebildet, die leiterbahnberandete Schlitze der Leiterplatte durchgreifen und dabei mit Vorsprüngen unter Kontaktanpreßdruck an Abschirmpotential aufweisenden Leiterbahnen anliegen. Die freien Endbereiche der Laschen treten unter elektrischer Kontaktgabe gegen die andere Halbschale. Einerseits erhält die andere Halbschale dadurch eine Befestigung, andererseits erfolgt die elektrische Verbindung zum Abschirmpotential. Durch die Vorsprünge, die unter Kontaktanpreßdruck die Schlitze der Leiterplatte durchgreifen wird die eine Halbschale an der Leiterplatte festgelegt. Durch die Anlage der Vorsprünge an den das Abschirmpotential führenden Leiterbahnen der Leiterplatte erfolgt eine gute HF-Abschirmung. Für eine Montage ist es daher lediglich erforderlich, die mit Laschen versehene Halbschale an der Leiterplatte festzuklipsen und dann auf die freien Endbereiche der Laschen die anderer Halbschale unter Kontaktgabe aufzusetzen.

Vorzugsweise weisen die Vorsprünge in das Behälterinnere.

Insbesondere ist vorgesehen, daß die Vorsprünge auf der Seite der Leiterplatte liegen, die den freien Endbereichen der Laschen zugeordnet ist.

Wie bereits angedeutet, nimmt die eine Halbschale durch Hintergriff der Vorsprünge eine Klipsstellung an der Leiterplatte ein. Durch das Einklipsen werden aufgrund der Vorsprünge die Laschen nach außen gespreizt, wodurch sie mit besonders hohem Anpreßdruck gegen die Innenseite der anderen Halbschale treten. Dies unterstützt die Halte- und Kontaktwirkung.

Vorteilhaft ist es, wenn an den Endbereichen der Laschen Erhebungen ausgebildet sind, die auf den Laschenaußenseiten liegen und gegen die Innenwand der anderen Halbschale treten. Durch diese Erhebungen werden somit definierte Kontaktbereiche zur anderen Halbschale gebildet. Für eine besonders sichere Befestigung können an der anderen Halbschale Vertiefungen ausgebildet sein, in die die Erhebungen treten.

Die Vorsprünge und/oder Erhebungen sind vorzugsweise von Sicken gebildet. Diese lassen sich besonders einfach durch Verformungsarbeiten aus dem Blechmaterial der Laschen herstellen.

Alternativ ist es jedoch auch möglich, daß die Vorsprünge und/oder Erhebungen von Biegekanten gebildet werden. Damit die Biegekanten über den übrigen Laschenbereich vortreten, ist eine Art Abkröpfung notwendig, das heißt, zunächst wird ein Bereich der Lasche derart verformt, daß er gegenüber dem übrigen Laschenabschnitt vortritt und dann wird daran die Biegekante gebildet, die den Vorsprung und/oder die Erhebung darstellt.

Schließlich ist es auch möglich, die Erhebungen von nach außen umgebogenen Enden der Laschen zu bilden. Durch das Umbiegen wird ein nach außen hervortretender Materialabschnitt der Lasche erzeugt, der einen definierten Kontaktbereich zur anderen Halbschale bildet.

Nach einer Weiterbildung der Erfindung ist vorgesehen, daß eine Teilanzahl der Laschen zur Klipsbefestigung an der Leiterplatte ausgebildet sind und daß die übrigen Laschen derart verschränkt nach außen abgebogen sind, daß sie mit erhöhtem Klemmdruck die andere Halbschale beaufschlagen. Insbesondere können die Laschen alternierend zur Klipsbefestigung bzw. Kontaktgabe zur anderen Halbschale eingesetzt werden.

Es ist auch möglich, daß zumindest einige der Laschen Deckungswandungsschlitze der anderen Halbschale mit ihren Endabschnitten durchgreifen. Diese Endabschnitte können umgebogen oder aber relativ zu den übrigen Laschenbereichen verdreht werden, so daß ein fester Sitz entsteht. Hierdurch werden beide Halbschalen mechanisch fest unter elektrischer Kontaktgabe gehalten.

Schließlich ist es vorteilhaft, wenn die andere Halbschale einen nach außen weisenden, flanschartigen Rand aufweist, der auf den Leiterbahnen der Leiterplatte aufliegt. Diese Leiterbahnen führen das Abschirmpotential, so daß eine zusätzliche elektrische Verbindung-hergestellt ist.

### Zeichnung

Die Erfindung wird im folgenden anhand der Figuren näher erläutert. Es zeigen:
- Figur 1: eine Explosionsdarstellung eines einen Bereich einer Leiterplatte umgreifenden Abschirmbehältnis',
- Figur 2: eine Schnittdarstellung entlang der Linie A-B in Figur 1,
- Figur 3: eine Detaildarstellung der Laschenausbildung gemäß Figur 2,
- Figur 4: ein weiteres Ausführungsbeispiel einer Laschenausbildung,
- Figur 5: ein weiteres Ausführungsbeispiel einer Laschenausbildung,
- Figur 6: ein anderes Ausführungsbeispiel einer Anordnung gemäß Figur 2,
- Figur 7: ein weiteres Ausführungsbeispiel gemäß einer Anordnung der Figur 2 und
- Figur 8: ein letztes Ausführungsbeispiel gemäß der Anordnung in Figur 2.

### Beschreibung von Ausführungsbeispielen

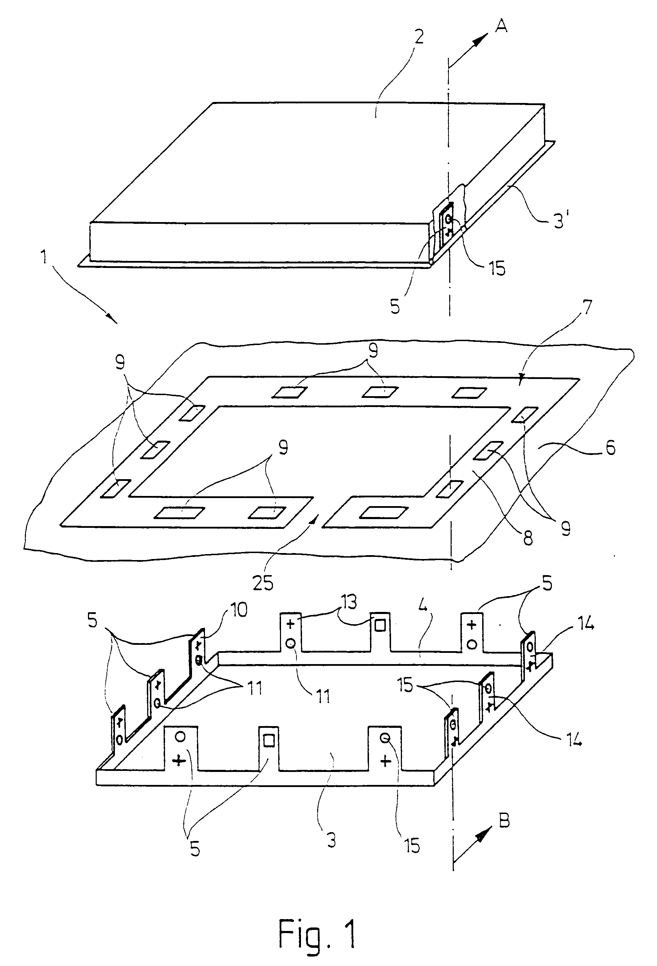

Die Figur 1 zeigt ein Abschirmbehältnis 1, das aus zwei Halbschalen 2 und 3 besteht. Jeder Halbschale ist in Form eines einseitig offenen Quarders ausgebildet, wobei der Grundriß beider Quarder etwa gleichgroß ist.

Die Halbschale 2 weist einen flaschartigen, nach außen weisenden Rand 3′ auf. Von dem Rand 4 der Halbschale 3 gehen einstückig Laschen 5 aus. Ferner zeigt die Figur 1 einen Bereich einer Leiterplatte 6, der von einem von Leiterbahnen 7 gebildeten Massering 8 berandet wird. Der Massering 8 weist daher Abschirmpotential auf. Insbesondere handelt es sich um eine beidseitig kaschierte Leiterplatte 6, so daß auf beiden Seiten der Leiterplatte ein Massering 8 vorgesehen ist.

Die Leiterplatte 6 wird von den Laschen 5 zugeordneten Schlitzen 9 durchsetzt, die in den Masseringen 8 liegen. Die Innenseiten der Schlitze 9 sind metallisiert, so daß zwischen den auf beiden Leiterplattenseiten liegenden Masseringe 8 elektrische Durchkontaktierungen gebildet sind.

Auf den Lascheninnenseiten 10 sind Vorsprünge 11 derart ausgebildet, daß sie die Schlitze 9 passieren können. Diese Vorsprünge 11 sind in den Figuren 1 bis 8 von Sicken 12 gebildet. Die freien Endbereiche 13 der Laschen 5 weisen auf den Laschenaußenseiten 14 Erhebungen 15 auf.

Die Anordnung ist nun derart ausgebildet, daß bei der Montage die Laschen 5 der Halbschale 3 in die Schlitze 9 der Leiterplatte 6 soweit eingesteckt werden, daß die Sicken 12 die Schlitze 9 passieren und hinter die entsprechenden Schlitzränder klipsen. Hierdurch wird die Halbschale 3 an der Leiterplatte 6 festgelegt. Dabei liegen die Vorsprünge 11 unter Kontaktanpreßdruck an den Leiterbahnen 7 an, so daß eine elektrische Verbindung zwischen diesen und der Halbschale 3 hergestellt wird, welche aus elektrisch leitendem Material besteht. Die ebenfalls aus elektrisch leitendem Material bestehende andere Halbschale 2 wird nunmehr über die freien Endbereiche 13 der Laschen 5 gestülpt, wodurch eine gute elektrische Kontaktgabe erzielt wird. Diese elektrische Kontaktgabe ist insbesondere dadurch bedingt, daß durch das Abstützen der Vorsprünge 11 die Laschen 5 nach außen abgespreizt werden, mithin eine Schrägstellung einnehmen, bevor die andere Halbschale 2 aufgesetzt wird. Durch das Aufsetzen der Halbschale 2 treten die freien Endbereiche 13 nach innen unter entsprechendem Anpreßdruck an der Innenwand 16 der Halbschale 2. Die Halbschale 2 wird derart weit aufgesteckt, bis ihr Rand 3′ auf der entsprechenden Leiterbahn 7 der Leiterplatte 6 flächig aufliegt. Hier erfolgt daher nochmals eine Kontaktgabe mit dem Abschirmpotential.

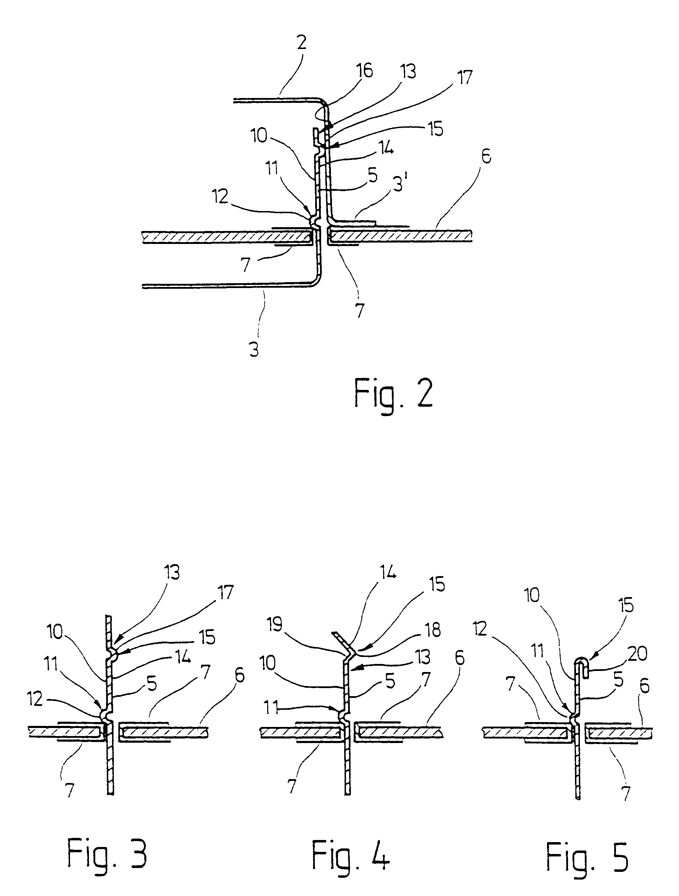

Nach den Ausführungsbeispielen der Figuren 2 und 3 sind die Erhebungen 15 ebenfalls als Sicken 17 ausgebildet. Alternativ kann gemäß Figur 4 jedoch vorgesehen sein, daß jede Erhebung 15 von einer Biegekante 18 gebildet ist. Damit die Biegekante 18 über den übrigen Bereich der entsprechenden Lasche 5 vorsteht, wird zunächst ein Abschnitt 19 der Lasche 5 nach außen abgebogen und daran die Biegekante 18 gebildet.

Ferner ist es gemäß dem Ausführungsbeispiel der Figur 5 auch möglich, daß die Erhebung 15 von einem nach außen umgebogenen Ende 20 der Lasche 5 gebildet wird.

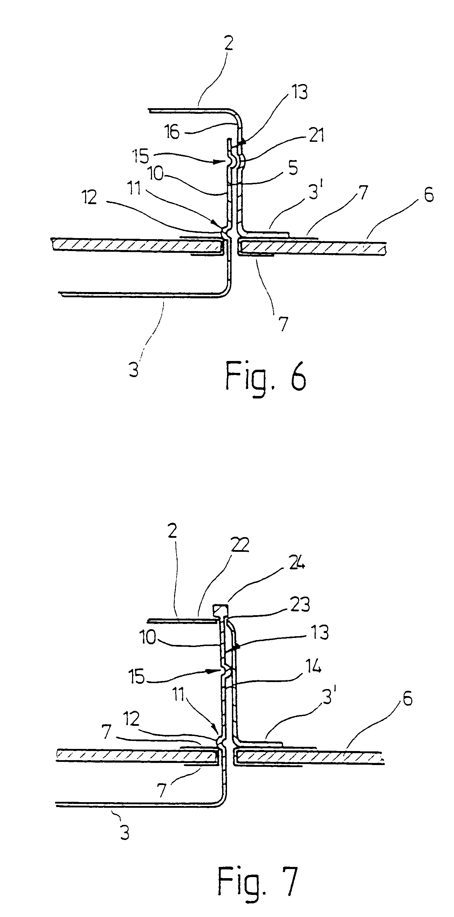

Um die Halbschale 2 besonders sicher und fest an den Laschen 5 zu halten, sind an dieser Vertiefungen 21 ausgebildet, in die die Erhebungen 15 eingreifen (Figur 6).

Im Ausführungsbeispiel der Figur 7 weist eine Deckenwandung 22 der Halbschale 2 entsprechende Deckenwandungsschlitze 23 auf, die von Endabschnitten 24 der Laschen 5 durchgriffen werden. Zur Halterung und zusätzlichen Kontaktgabe können die Endabschnitte 24 gegenüber den übrigen Bereichen der Laschen 7 verdreht werden (Figur 7).

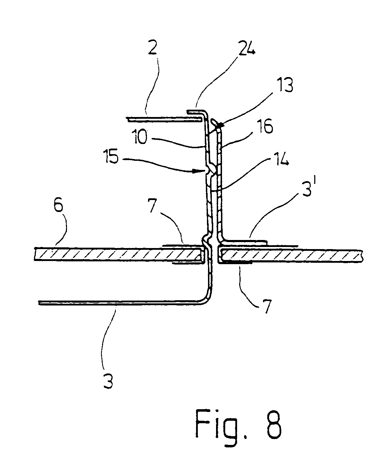

Im Ausführungsbeispiel der Figur 8 sind die Endabschnitte 24 umgebogen, so daß sie auf der Außenseite der Halbschale 2 aufliegen.

Durch die erfindungsgemäße Ausbildung wird also beim Aufsetzen der Halbschale 3 ein sicherer Kontakt zu den Masseringen 8 hergestellt und gleichzeitig eine Halterung vorgenommen. Denkbar ist dabei auch eine Verschränkung der einzelnen Laschen 5 derart, daß einige von ihnen im wesentlichen die mechanische Halterung sowie die erwähnte Kontaktgabe mit den Leiterbahnen 7 vornehmen und daß die übrigen Laschen 5 nach außen abgebogen sind, so daß sie einen festen Kontaktdruck zur Halbschale 2 herstellen.

Die in der Figur 6 dargestellten Vertiefungen 21 können nach anderen Ausführungsbeispielen auch als Aussparungen oder umlaufende bzw. unterbrochene Nut ausgebildet werden.

Wie aus der Figur 1 ersichtlich, ist der Massering 8 nicht durchgehend ausgebildet, sondern von einem Leiterbahndurchgang 25 unterbrochen. Auch die zwischen den Laschen 5 liegenden Randbereiche der Halbschale 3 bildet einen entsprechenden Spalt, so daß kein vollständiges Schließen der beiden Halbschalen 2 und 3 erzielt werden kann. Dennoch ist eine optimale Abschirmwirkung erzielt, wobei diese insbesondere noch dadurch verbessert werden kann, daß die beiden, auf der Ober- und der Unterseite der Leiterplatte 6 liegenden Masseringe 8 mittels einer Vielzahl von Durchkontaktierungen miteinander verbunden sind. Überdies kann eine Vielzahl von Laschen 5 eingesetzt werden, so daß die Abstände zwischen den einzelnen Laschen sehr klein werden, wobei jedoch die mechanische Schwächung der Leiterplatte aufgrund der Schlitze 9 Berücksichtigung finden muß. Die Zahl der erwähnten Durchkontaktierungen wird dadurch erhöht, daß -wie bereits erwähnt- die Wandungen der Schlitze 9 metallisiert sind.

## Patentansprüche

1. Abschi,mbehältnis für einen Bereich einer Leiterplatte, mit einer auf der einen Seite der Leiterplatte angeordneten ersten und einer auf der anderen Seite der Leiterplatte befindlichen zweiten Halbschale sowie mit Befestigungsmitteln für die Halbschalen, **dadurch** **gekennzeichnet**, daß von dem Rand einer der Halbschalen (2,3) Laschen (5) ausgehen, die leiterbahnberandete Schlitze (9) der Leiterplatte (6) durchgreifen und mit Vorsprüngen (11) versehen sind, die an Abschirmpotential aufweisenden Leiterbahnen (7) unter Kontaktanpreßdruck anliegen und daß die freien Endbereiche (13) der Laschen (5) gegen die andere Halbschale (2) unter elektrischer Kontaktgabe treten.

2. Abschirmbehältnis nach Anspruch 1, **dadurch** **gekennzeichnet**, daß die Vorsprünge (11) in das Behältnisinnere weisen.

3. Abschirmbehältnis nach einem der vorhergehenden Ansprüche, **dadurch** **gekennzeichnet**, daß die Vorsprünge (11) auf der Seite der Leiterplatte (6) liegen, die den freien Endbereichen (13) der Laschen (5) zugeordnet ist.

4. Abschirmbehältnis nach einem der vorhergehenden Ansprüche, **dadurch** **gekennzeichnet**, daß die eine Halbschale (3) durch Hintergriff der Vorsprünge (11) eine Klipsstellung an der Leiterplatte (6) einnimmt.

5. Abschirmbehältnis nach einem der vorhergehenden Ansprüche, **dadurch** **gekennzeichnet**, daß die andere Halbschale (2) die Endbereiche (13) der Laschen (5) klemmend übergreift.

6. Abschirmbehältnis nach einem der vorhergehenden Ansprüche, **dadurch** **gekennzeichnet**, daß an den Endbereichen (13) der Laschen (5) Erhebungen (15) ausgebildet sind, die auf den Laschenaußenseiten (14) liegen und gegen die Innenwand (16) der anderen Halbschale (2) treten.

7. Abschirmbehältnis nach einem der vorhergehenden Ansprüche, **dadurch** **gekennzeichnet**, daß an der anderen Halbschale (2) Vertiefungen (21) ausgebildet sind, in die die Erhebungen (15) treten.

8. Abschirmbehältnis nach einem der vorhergehenden Ansprüche, **dadurch** **gekennzeichnet**, daß die Vorsprünge (11) und/oder Erhebung (15) von Sicken (12,17) gebildet sind.

9. Abschirmbehältnis nach einem der vorhergehenden Ansprüche, **dadurch** **gekennzeichnet**, daß die Vorsprünge (11) und/oder Erhebungen (15) von Biegekanten (18) gebildet sind.

10. Abschirmbehältnis nach einem der vorhergehenden Ansprüche, **dadurch** **gekennzeichnet**, daß die Erhebungen (15) von nach außen umgebogenen Enden (20) der Laschen (5) gebildet sind.

11. Abschirmbehältnis nach einem der vorhergehenden Ansprüche, **dadurch** **gekennzeichnet**, daß eine Teilanzahl der Laschen (5) zur Klipsbefestigung an der Leiterplatte (6) ausgebildet sind und daß die übrigen Laschen (5) derart verschränkt nach außen abgebogen sind, daß sie mit erhöhtem Klemmdruck die andere Halbschale (2) beaufschlagen.

12. Abschirmbehältnis nach einem der vorhergehenden Ansprüche, **dadurch** **gekennzeichnet**, daß mindestens einige der Laschen (5) Deckenwandungsschlitze (23) der anderen Halbschale (2) mit ihren Endabschnitten (24) durchgreifen.

13. Abschirmbehältnis nach einem der vorhergehenden Ansprüche, **dadurch** **gekennzeichnet**, daß die Endabschnitte (24) umgebogen sind.

14. Abschirmbehältnis nach einem der vorhergehenden Ansprüche, **dadurch** **gekennzeichnet**, daß die Endabschnitte (24) verdreht ausgebildet sind.

15. Abschirmbehältnis nach einem der vorhergehenden Ansprüche, **dadurch** **gekennzeichnet**, daß die andere Halbschale (2) eïnen nach außen weisenden, flanschartigen Rand (3′) aufweist, der auf den Leiterbahnen (7) der Leiterplatte (6) aufliegt.

## Claims

1. Screening case for an area of a circuit board, comprising a first half shell arranged on one side of the circuit board and a second half shell located on the other side of the circuit board and comprising mounting means for the half shells, characterised in that tabs (5) project from the edge of one of the half shells (2, 3), which tabs penetrate through conductor-track-edged slots (9) of the circuit board (6) and are provided with projections (11) which rest under contact pressure against conductor tracks (7) having screening potential, and in that the free end areas (13) of the tabs (5) act against the other half shell (2), at the same time providing electrical contact.

2. Screening case according to Claim 1, characterised in that the projections (11) point into the interior of the case.

3. Screening case according to one of the preceding claims, characterised in that the projections (11) are located on the side of the circuit board (6) which is allocated to the free end areas (13) of the tabs (5).

4. Screening case according to one of the preceding claims, characterised in that one half shell (3) assumes a clipping position on the circuit board (6) by engaging behind the projections (11).

5. Screening case according to one of the preceding claims, characterised in that the other half shell (2) engages clampingly over the end areas (13) of the tabs (5).

6. Screening case according to one of the preceding claims, characterised in that at the end areas (13) of the tabs (5), raised parts (15) are formed which are located on the outsides (14) of the tabs and act against the inside wall (16) of the other half shell (2).

7. Screening case according to one of the preceding claims, characterised in that recesses (21) on the other half shell (2) into which the raised parts (15) enter are formed.

8. Screening case according to one of the preceding claims, characterised in that the projections (11) and/or raised parts (15) are formed by beads (12, 17).

9. Screening case according to one of the preceding claims, characterised in that the projections (11) and/or raised parts (15) are formed by bent edges (18).

10. Screening case according to one of the preceding claims, characterised in that the raised parts (15) are formed by ends (20) of the tabs (5) which are bent over towards the outside.

11. Screening case according to one of the preceding claims, characterised in that some of the tabs (5) are constructed for clipping-in mounting on the circuit board (6) and in that the remaining tabs (5) are bent away towards the outside in such a staggered manner that they bear against the other half shell (2) with increased clamping pressure.

12. Screening case according to one of the preceding claims, characterised in that at least some of the tabs (5) penetrate with their end sections (24) through cover wall slots (23) in the other half shell (2).

13. Screening case according to one of the preceding claims, characterised in that the end sections (24) are bent over.

14. Screening case according to one of the preceding claims, characterised in that the end sections (24) are of twisted construction.

15. Screening case according to one of the preceding claims, characterised in that the other half shell (2) exhibits an outwardly pointing flange-like edge (3′) which rests against the conductor tracks (7) of the circuit board (6).

## Revendications

1. Enveloppe de blindage pour une zone d'une carte à circuits imprimés, avec une première demi-coquille disposée sur l'un des côtés de la carte à circuits imprimés et une deuxième demi-coquille se trouvant sur l'autre côté de la carte à circuits imprimés, ainsi qu'avec des moyens de fixation pour les demi-coquilles, enveloppe de blindage caractérisée en ce que du bord de l'une des demi-coquilles (2, 3) partent des pattes (5) qui viennent en prise dans des fentes (9) placées sur le bord des pistes de la carte à circuits imprimés (6) et qui sont pourvues de saillies (11) reposant sur des pistes de la carte à circuits imprimés (7) présentant un potentiel de blindage lorsqu'on exerce une pression de contact, et en ce que les zones terminales libres (13) des pattes (5) viennent contre l'autre demi-coquille (2) avec mise en contact électrique.

2. Enveloppe de blindage selon la revendication 1, caractérisée en ce que les saillies (11) sont dirigées vers l'intérieur de l'enveloppe.

3. Enveloppe de blindage selon l'une des revendications précédentes, caractérisée en ce que les saillies (11) se trouvent sur le côté de la carte à circuits imprimés (6) qui est associé aux zones terminales libres (13) des pattes (5).

4. Enveloppe de blindage selon l'une des revendications précédentes, caractérisée en ce que l'une des demi-coquilles, la demi-coquille (3) prend une position d'enclipsage sur la carte à circuits imprimés (6) en venant en prise en arrière des saillies (11).

5. Enveloppe de blindage selon l'une des revendications précédentes, caractérisée en ce que l'autre demi-coquille (2) vient en prise par serrage sur les zones terminales (13) des pattes (5).

6. Enveloppe de blindage selon l'une des revendications précédentes, caractérisée en ce que l'on constitue sur les zones terminales (13) des pattes (5) des surélévations (15) qui se trouvent sur les faces extérieures (14) des pattes et viennent contre la paroi intérieure (16) de l'autre demi-coquille (2).

7. Enveloppe de blindage selon l'une des revendications précédentes, caractérisée en ce que l'on constitue sur l'autre demi-coquille (2) des renfoncements (21) dans lesquels viennent les surélévations (15).

8. Enveloppe de blindage selon l'une des revendications précédentes, caractérisée en ce que les saillies (11) et/ou les surélévations (15) sont constituées par des moulures (12, 17).

9. Enveloppe de blindage selon l'une des revendications précédentes, caractérisée en ce que les saillies (11) et/ou les surélévations (15) sont constituées par des arêtes (18) formées par pliage.

10. Enveloppe de blindage selon l'une des revendications précédentes, caractérisée en ce que les surélévations (15) sont constituées par des extrémités repliées vers l'extérieur (20) des pattes (5).

11. Enveloppe de blindage selon l'une des revendications précédentes, caractérisée en ce qu'un certain nombre des pattes (5) est constitué pour la fixation par enclipsage sur la carte à circuits imprimés (6), et en ce que les autres pattes (5) sont repliées vers l'extérieur en étant entrelacées de telle façon qu'elles sollicitent l'autre demi-coquille (2) avec une pression de serrage accrue.

12. Enveloppe de blindage selon l'une des revendications précédentes, caractérisée en ce qu'au moins quelques unes des pattes (5) viennent en prise avec les fentes (23) dans la paroi de recouvrement de l'autre demi-coquille (2), par leurs sections terminales (24).

13. Enveloppe de blindage selon l'une des revendications précédentes, caractérisée en ce que les sections terminales (24) sont repliées.

14. Enveloppe de blindage selon l'une des revendications précédentes, caractérisée en ce que les sections terminales (24) sont constituées en étant tordues.

15. Enveloppe de blindage selon l'une des revendications précédentes, caractérisée en ce que l'autre demi-coquille (2) présente un bord (3′) orienté vers l'extérieur, en forme de bride, qui repose sur les pistes (7) de la carte à circuits imprimés.
